(19) Europäisches Patentamt
European Patent Office
Office européen des brevets

(11) **EP 2 682 764 B1**

(12) **EUROPEAN PATENT SPECIFICATION**

(45) Date of publication and mention
of the grant of the patent:
**19.08.2015 Bulletin 2015/34**

(51) Int Cl.:
*G01R 15/20* (2006.01)          *G01R 33/04* (2006.01)
*G01R 33/09* (2006.01)          *G01R 31/02* (2006.01)
*G01R 33/025* (2006.01)         *G01R 33/07* (2006.01)

(21) Application number: **13174935.0**

(22) Date of filing: **03.07.2013**

(54) **Current transducer for measuring an electrical current**

Stromwandler zur Messung eines elektrischen Stromes

Transducteur de courant pour mesurer un courant électrique

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **06.07.2012 EP 12175456**

(43) Date of publication of application:
**08.01.2014 Bulletin 2014/02**

(73) Proprietor: **Senis AG
6300 Zug (CH)**

(72) Inventors:
• **Popovic, Radivoje
6300 Zug (CH)**
• **Dimitrijevic, Sasa
18251 Mramor, Nis (RS)**
• **Blagojevic, Marjan
18000 Nis (RS)**
• **Walker, Ian James
Woodside, CA California 94062 (US)**
• **Law, Karron Louis
Cheney, WA Washington 99004 (US)**

(74) Representative: **Falk, Urs
Patentanwaltsbüro Dr. Urs Falk
Eichholzweg 9A
6312 Steinhausen (CH)**

(56) References cited:
JP-A- 2001 033 491     JP-A- 2006 071 457
JP-A- 2008 224 260     US-A- 5 241 263

## Description

FIELD OF THE INVENTION

The invention relates to a current transducer for measuring an electrical current flowing through a cable.

BACKGROUND OF THE INVENTION

One important application of magnetic transducers is non-invasive current measurement (without breaking the cable carrying a current) by measuring the magnetic field produced by the current. A convenient way to perform such current measurement is by using a current transducer, including a so-called clamp-on current transducer. A current transducer capable of measuring DC and AC currents usually consists of a combination of a ferro-magnetic core, which encloses a current-carrying cable, and a magnetic transducer. The lowest value of the current that can be measured via the associated magnetic field critically depends on the intrinsic noise of the magnetic transducer and on the sensitivity of the measurement system to external magnetic fields. The accuracy of a clamp-on ammeter is also limited by the dependence of the measurement result on the position of the enclosed cable with respect to the symmetry axis of the ferromagnetic core. The JP 2006 07 1457 A discloses a current measuring device comprising two magnetic sensors placed in two different gaps of the same core.

Big electrical machines of all kinds and for different purposes, like for example electricity generators, may develop during manufacture or in the course of time a current leakage path which may result in the worst case in a short circuit. There is a high risk that the machine is damaged if a short circuit occurs. To decrease the risk, big electrical machines are periodically tested in order to detect, and, if detected, to localize a current leakage path. For such tests very sensitive and very disturbance-immune clamp-on ammeters are needed.

DISCLOSURE OF THE INVENTION

A first object of the invention is to develop a magnetic transducer with the following characteristics:

- very high DC and low-frequency AC magnetic resolution - down to or below 1nT;
- capable of measuring either a magnetic field at a certain location, or a difference of magnetic fields at two locations;
- very small dimensions of the magnetic-field-sensitive part of the transducer (which is further referred to as magnetic sensor) - down to or below 1 mm (so that the sensor can be fitted into or near an air gap of a ferromagnetic core, the gap being of the order of 1 mm).

A second object of the invention is to develop an electrical current transducer

- capable of measuring very low electrical DC and AC currents, down to 100 $\mu$A or even down to the order of 1 $\mu$A,
- with high immunity to disturbing magnetic fields, particularly those produced by other current-carrying cables,
- and with low sensitivity to the position of the enclosed current-carrying cable.

Still another object of the invention is to develop a system and method for detecting and locating a current leakage path of high electrical resistance in an electrical machine. High electrical resistance means a resistance in the order of magnitude of 100 M$\Omega$. The system should therefore be capable of measuring electrical DC currents down to 100 $\mu$A or even down to the order of 1 $\mu$A.

SHORT DESCRIPTION OF THE INVENTION

According to a first aspect, the invention is directed to a current transducer for measuring a current flowing through a cable, the current transducer comprising a head comprising at least two ferromagnetic cores enclosing the cable, each core having an air gap and a magnetic field sensor placed at the air gap, wherein the ferromagnetic cores are positioned approximately parallel to each other and spaced by a predetermined distance from each other along an axis and rotated by a predetermined angle of rotation around the axis with respect to each other, so that the air gaps of the ferromagnetic cores are situated at different angles. The invention is defined by the current transducer of claim 1. Further aspects are defined in the dependent claims.

In a preferred embodiment, the number of the ferromagnetic cores of the head is two and the predetermined angle of rotation is approximately 180°, so that the air gaps of the two ferromagnetic cores are situated at diametrically opposite sides with respect to the axis.

In another preferred embodiment, the number of the ferromagnetic cores of the head is four and the predetermined angle of rotation is approximately 90°, so that the air gaps of the four ferromagnetic cores are mutually rotated for an angle of approximately 90°.

Each ferromagnetic core may be composed of at least two pieces, so that the ferromagnetic cores can be assembled around the cable without disconnecting the cable.

Preferably, the magnetic field sensors are Hall devices or magnetoresistive sensors, e.g. AMR sensors, which are placed within or adjacent the air gaps of the ferromagnetic cores.

Such a current transducer may further comprise a transformer coupled to the magnetic field sensors, a fully differential preamplifier coupled to the transformer, a phase sensitive detector coupled to the preamplifier, and

a logic block configured to operate the magnetic field sensors to provide an AC output signal.

According to a second aspect, the invention is related to a magnetic transducer, comprising a magnetic field sensor, and
an electronic circuit comprising
a current source providing a supply current,
a transformer comprising two input terminals and two output terminals,
a fully differential preamplifier comprising two input terminals and two output terminals, the two input terminals coupled to said two output terminals of the transformer,
a phase sensitive detector comprising two input terminals coupled to the output terminals of the preamplifier and providing a DC output voltage, and
a logic block configured to operate the magnetic field sensor to provide an AC output voltage, wherein
the magnetic field sensor is a Hall element comprising four terminals serving to receive a supply current and to deliver an output voltage and the logic block comprises circuitry to couple the Hall element to the current source and to the input terminals of the transformer according to a predetermined spinning current scheme, or wherein
the magnetic field sensor is an AMR sensor comprising four terminals serving to receive a supply current and to deliver an output voltage and two terminals serving to receive set and reset current pulses that change the polarity of the output voltage, wherein the terminals serving to receive a supply current are coupled to the current source, the terminals serving to deliver an output voltage are coupled to the input terminals of the transformer, and the terminals serving to receive set and reset current pulses are coupled to the logic block, and the logic block comprises circuitry to deliver set and reset current pulses according to a predetermined frequency, or wherein
the magnetic field sensor is a fluxgate sensor comprising four terminals serving to receive an excitation current and to deliver an output voltage, wherein the terminals serving to receive the excitation current are coupled to the current source and the terminals serving to deliver an output voltage are coupled to the input terminals of the transformer, wherein the logic block comprises circuitry to control the current source to provide the supply current as an AC current having a predetermined frequency.

According to a third aspect, the invention is related to a magnetic transducer, comprising
a first magnetic field sensor and a second magnetic field sensor, and
an electronic circuit comprising
a first current source providing a first supply current,
a second current source providing a second supply current,
a transformer, comprising at least one core, two primary windings and at least one secondary winding,
a fully differential preamplifier comprising two input terminals and two output terminals, the two input terminals coupled to two output terminals of the at least one secondary winding of the transformer,
a phase sensitive detector comprising two input terminals coupled to the output terminals of the preamplifier and providing a DC output voltage, and
a logic block configured to operate the magnetic field sensors to provide an AC output voltage, wherein
the first magnetic field sensor and the second magnetic field sensor each is a Hall element comprising four terminals serving to receive a supply current and to deliver an output voltage, and the logic block comprises circuitry to couple the first Hall element to the first current source and to the first primary winding of the transformer according to a predetermined spinning current scheme and to couple the second Hall element to the second current source and to the second primary winding of the transformer according to the predetermined spinning current scheme, or wherein
the first magnetic field sensor and the second magnetic field sensor each is an AMR sensor comprising four terminals serving to receive a supply current and to deliver an output voltage and two terminals serving to receive set and reset current pulses that change the polarity of the output voltage, wherein the terminals serving to receive a supply current of the first AMR sensor are coupled to the first current source, the terminals serving to deliver an output voltage of the first AMR sensor are coupled to the first primary winding of the transformer, the terminals serving to receive a supply current of the second AMR sensor are coupled to the second current source, the terminals serving to deliver an output voltage of the second AMR sensor are coupled to the second primary winding of the transformer, and the terminals serving to receive set and reset current pulses of the first and second AMR sensor are coupled to the logic block, and the logic block comprises circuitry to deliver set and reset current pulses according to a predetermined frequency, or wherein
the first magnetic field sensor and the second magnetic field sensor each is a fluxgate sensor comprising four terminals serving to receive an excitation current and to deliver an output voltage, wherein the terminals serving to receive the excitation current of the first fluxgate sensor are coupled to the first current source and the terminals serving to deliver an output voltage of the first fluxgate sensor are coupled to the first primary winding of the transformer, the terminals serving to receive the excitation current of the second fluxgate sensor are coupled to the second current source and the terminals serving to deliver an output voltage of the second fluxgate sensor are coupled to the second primary winding of the transformer, wherein the logic block comprises circuitry to control the current sources to provide the supply current as an AC current having a predetermined frequency.

Preferably the current source(s) is/are configured such that a voltage appearing at the first voltage terminal and a voltage appearing at the second voltage terminal of the respective magnetic field sensor as referenced to ground GND are about equal in size but have opposite signs.

Such a magnetic transducer may be used in a current transducer having a head comprising a single ferromagnetic core with an air gap, wherein the magnetic field sensor is fixed within or adjacent the air gap of the ferromagnetic core and wherein the magnetic field sensor is coupled to the transformer of the magnetic transducer.

Such a magnetic transducer may also be used in a current transducer having a head comprising a first ferromagnetic core with an air gap and a second ferromagnetic core with an air gap, wherein the first magnetic field sensor is fixed within or adjacent the air gap of the first ferromagnetic core and the second magnetic field sensor is fixed within or adjacent the air gap of the second ferromagnetic core.

Generally, the magnetic transducer of the invention and the heads with the ferromagnetic cores of the invention can be combined in any imaginable manner.

BRIEF DESCRIPTION OF THE DRAWINGS

The accompanying drawings, which are incorporated into and constitute a part of this specification, illustrate one or more embodiments of the present invention and, together with the detailed description, serve to explain the principles and implementations of the invention. The figures are not to scale. In the drawings:

Fig. 1          shows a first embodiment of a magnetic transducer according to the invention,

Figs. 2, 3      show variants of the first embodiment of the magnetic transducer,

Figs. 4 to 7    show four phases of a spinning current method,

Fig. 8          shows a diagram illustrating the spinning current method,

Fig. 9          shows a preferred embodiment of a constant current source,

Fig. 10         shows a second embodiment of a magnetic transducer according to the invention,

Fig. 11         shows a circuit capable of producing set and reset current pulses,

Fig. 12         shows a third embodiment of a magnetic transducer according to the invention,

Fig. 13         shows a variant of the third embodiment of the magnetic transducer,

Fig. 14         shows a fourth embodiment of a magnetic transducer according to the invention,

Fig. 15         shows a fifth embodiment of a magnetic transducer according to the invention,

Fig. 16         shows a sixth embodiment of a magnetic transducer according to the invention,

Fig. 17         shows a head of the prior art having one ferromagnetic core and one magnetic sensor,

Fig. 18         shows a head of the prior art having one ferromagnetic core and two magnetic sensors,

Figs. 19-22     show schematic views of different embodiments of a head having one ferromagnetic core,

Fig. 23         shows a schematic view of a head having two ferromagnetic cores,

Figs. 24A, B    show an embodiment of such a head,

Fig. 25         shows a head comprising AMR sensors,

Figs. 26, 27    show details of a head comprising AMR sensors, and

Fig. 28         shows a schematic view of a head having four ferromagnetic cores.

DETAILED DESCRIPTION OF THE INVENTION

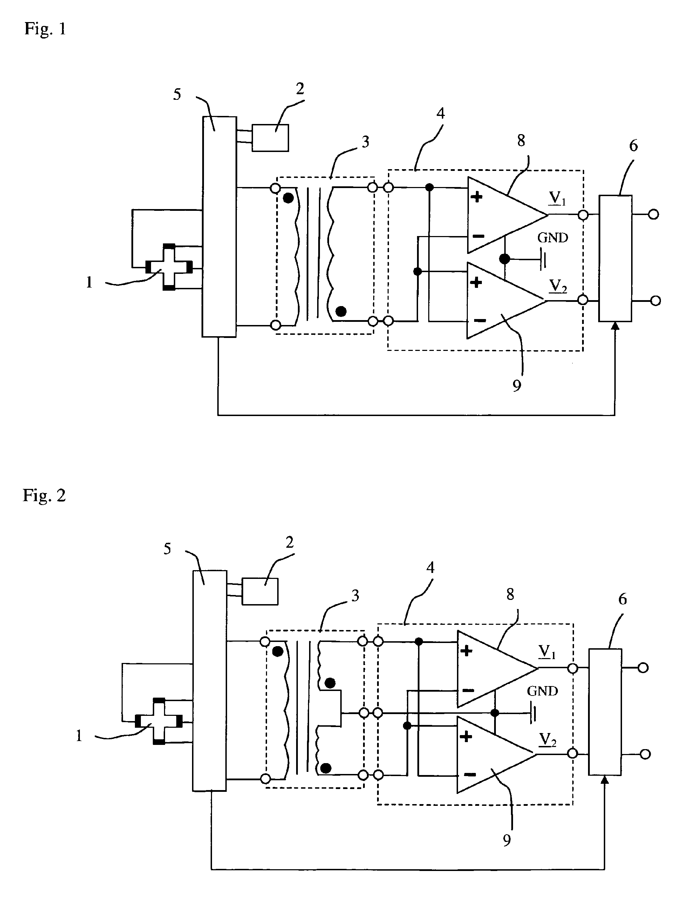

Fig. 1 shows a diagram of a first embodiment of a magnetic transducer according to the invention. The magnetic transducer comprises a magnetic field sensor and electrical circuitry to operate the magnetic field sensor. In this first embodiment, the magnetic field sensor is a Hall element 1. The electrical circuitry comprises a first current source 2 providing a supply current to the Hall element 1, a transformer 3, a preamplifier 4, a logic block 5 and a phase sensitive detector 6. The transformer 3 has a primary winding with two input terminals and a secondary winding with two output terminals. The preamplifier 4 is a fully differential amplifier having two input terminals and two output terminals. The first output terminal of the transformer 3 is coupled to the first input terminal of the preamplifier 4 and the second output terminal of the transformer 3 is coupled to the second input terminal of the preamplifier 4.

A Hall element is a magnetic field sensor having four terminals, namely two terminals for supplying a Hall current flowing through the Hall element and two terminals for tapping a Hall voltage. The term "Hall element" may mean a single Hall element but has to be understood as also to include a group of Hall elements forming a cluster. A cluster of Hall elements has a reduced offset and other advantageous properties. The Hall element my be: a conventional planar Hall element, sensitive to a magnetic field perpendicular to the device surface; or a vertical Hall element, sensitive to a magnetic field parallel with the device surface; or a Hall element (or a cluster of Hall elements) combined with magnetic concentrator(s), which is also sensitive to a magnetic field parallel with the device surface.

The logic block 5 generally serves to operate the magnetic field sensor, in this embodiment the Hall element 1, such as to produce an AC output signal as will be explained further below. The transformer 3 serves to amplify the AC output signal of the magnetic field sensor without adding substantial noise to the signal, and to block sensor offset voltage and low-frequency noise. The voltage gain of the magnetic field sensor's AC output signal, provided by the transformer 3, is equal to the ratio of the numbers of the secondary and primary windings. For example, this ratio could be about 10, but also any other convenient value.

The preamplifier 4 is designed for low noise input current. The preamplifier 4 may be composed of two discrete amplifiers, namely a first amplifier 8 and a second amplifier 9 each having a non-inverting input, an inverting input and an output terminal. The amplifiers 8, 9 are preferably differential amplifiers or instrumentation amplifiers. The non-inverting input of the first amplifier 8 is coupled to the inverting input of the second amplifier 9 and to the first input terminal of the preamplifier 4. The inverting input of the first amplifier 8 is coupled to the non-inverting input of the second amplifier 9 and to the second input terminal of the preamplifier 4. The voltage $V_1$ appearing at the output terminal of the first amplifier 8 and the voltage $V_2$ appearing at the output terminal of the second amplifier 9 are approximately of equal size but opposite sign with respect to ground GND, i.e. $V_1 \cong -V_2$. The output terminal of the first amplifier 8 and the output terminal of the second amplifier 9 form the output terminals of the preamplifier 4 and are coupled to input terminals of the phase sensitive detector 6. The phase sensitive detector 6 transforms the difference between the AC voltages $V_1$ and $V_2$ into a DC voltage and provides a DC output signal that is proportional to the magnetic field measured by the magnetic field sensor. The phase sensitive detector 6 generally includes appropriate filters. The transformer 3 is a single component with one core or may be composed of two individual transformers. In addition, the transformer 3 is adequately shielded against external disturbances.

Fig. 2 shows a first variant of the first embodiment where the transformer 3 has a secondary winding with three output terminals, one of the output terminals being a middle terminal. The middle terminal is coupled to ground GND, either directly or as shown to a ground terminal GND of the preamplifier 4.

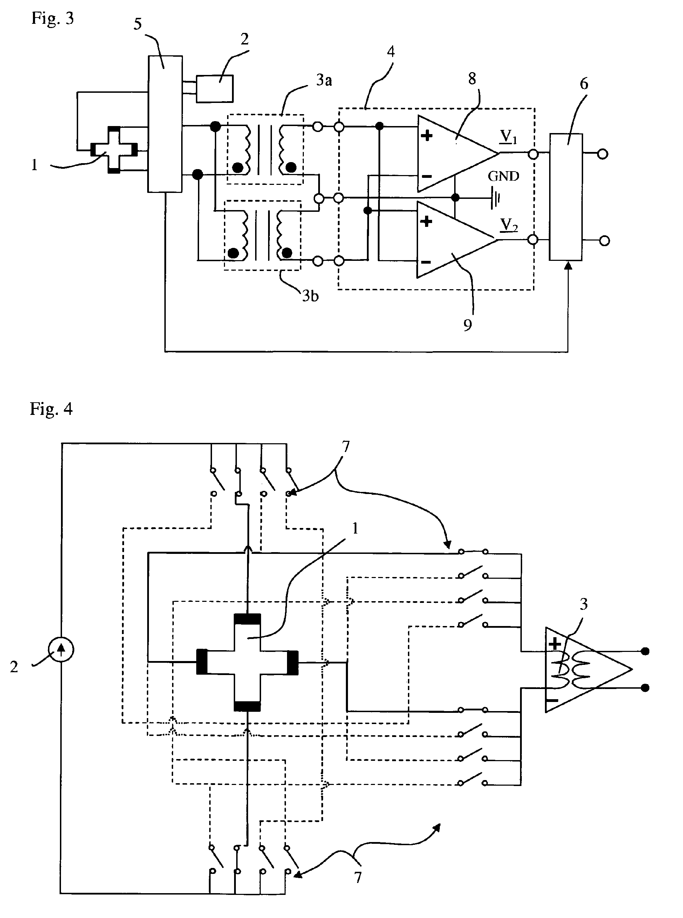

Fig. 3 shows a second variant of the first embodiment where the transformer 3 is composed of two transformers 3a and 3b. The primary windings of the two transformers 3a and 3b are coupled in a parallel manner, the secondary windings are coupled such that two of the four output terminals of the transformers 3a and 3b form a middle terminal. The middle terminal is coupled to ground GND, either directly or as shown to a ground terminal GND of the preamplifier 4.

In all these embodiments the Hall element 1 is operated according to the spinning current method and it is the logic block 5 that serves for this purpose. The spinning current method consists in coupling the Hall element 1 to the current source 2 and the transformer 3 in a cyclic manner running according to a predetermined time clock through four phases, namely phase 1, phase 2, phase 3 and phase 4 (shown in Figs. 4 to 7), or two phases only, namely phase 1 and phase 3. The logic block 5 comprises a clock generator and a plurality of electronic switches 7 for changing between the phases, and control circuitry. The logic block 5 is configured to open and close the electronic switches 7 in order to couple the terminals of the Hall element 1 to the current source 2 and to the input terminals of the transformer 3 according to a predetermined spinning current scheme which is a predetermined coupling sequence run through at a periodical clock derived from the clock generator. The preferred coupling sequence comprises four phases. Figs. 4 to 7 illustrate the state of the switches in the four phases exemplarily for the Hall element 1, the current source 2 and the transformer 3. The polarity of the Hall voltage in phase 1 and in phase 2 is opposite to the polarity of the Hall voltage in phase 3 and phase 4, so that the Hall voltage is supplied to the transformer as AC voltage. The spinning current method serves to separate the Hall voltage from the offset voltage. Any coupling scheme of the four phases is possible as long as it delivers the Hall voltage as an AC voltage and the offset voltage of the Hall element 1 as a DC voltage to the input terminals of the transformer 3. As the transformer 3 does not allow a DC voltage to pass through, the offset voltage of the Hall element 1 is eliminated. The logic block 5 is coupled to the phase sensitive detector 6 and sends the timing or clock signal derived from the clock generator to the phase sensitive detector 6.

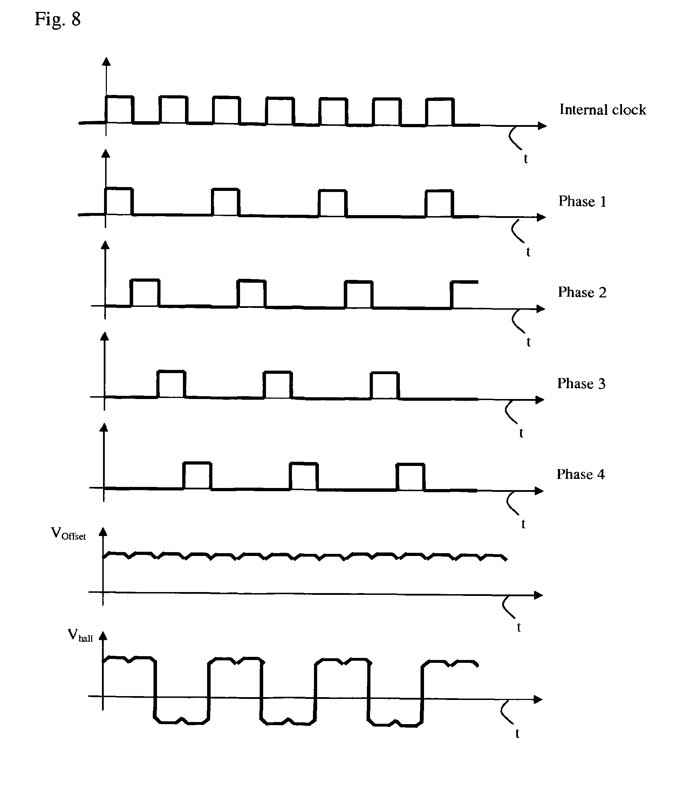

Fig. 8 illustrates the working of the spinning current method for the Hall element 1. From top to down the diagrams show:

- the internal clock signal (derived from the clock generator 27) which initiates the changes of the state of the switches 7 (Figs. 4 to 7) of the logic block 5 (Fig. 1),
- the time when the four phases are active (or with other words when each phase is the active one), and
- the last two diagrams show the DC component of the output signal of the Hall element which is called offset voltage $V_{offset}$ and the AC component of the output signal of the Hall element which is called Hall voltage $V_{hall}$.

The sequence of the four phases is chosen in this case such that a minimum of switches must change their state at the transition from one phase to the next which results in that the frequency of the Hall voltage $V_{hall}$ is half the frequency of the clock signal.

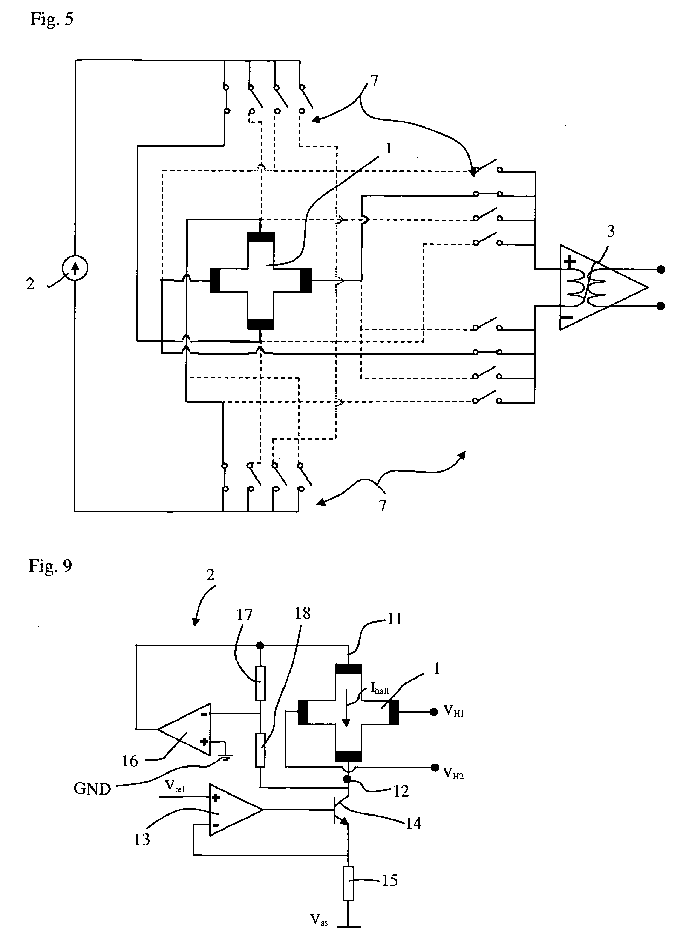

Fig. 9 shows a preferred embodiment of the current source 2 (and current source 29) which works as a constant current source. A Hall element 10 directly coupled to the terminals 11 and 12 of the current source 2 is also shown in order to understand the working way of the current source 2. The current source 2 is composed of a first sub-circuit comprising a first operational amplifier 13, a transistor 14 and a resistor 15, and a second sub-circuit comprising a second operational amplifier 16 and two resistors 17 and 18. The transistor 14 and the resistor 15 are coupled in series and the inverting input of the operational amplifier 13 is coupled to the junction between the transistor 14 and the resistor 15. A reference voltage $V_{ref}$ is applied to the non-inverting input of the operational amplifier 13. This first sub-circuit forms a circuit that can be called a "conventional type" constant current source and it may be replaced by any other type of conventional constant current source. The current source 2 of the present invention as realized with this preferred embodiment also comprises the second sub-circuit. The resistors 17 and 18 are coupled in series. A first terminal of the resistor 17 forms the first terminal of the current source 2, a first terminal of the resistor 18 is coupled to the transistor 14 and forms the second terminal of the current source 2. The second terminals of the resistors 17 and 18 are coupled with each other and coupled to the inverting input of the operational amplifier 16. The non-inverting input of the operational amplifier 16 is coupled to ground GND. The output of the operational amplifier 16 is coupled to the first terminal of the resistor 17. The second sub-circuit makes that the voltage $V_{H1}$ appearing at the first Hall voltage terminal and the voltage $V_{H2}$ appearing at the second Hall voltage terminal of the Hall element 10 as referenced to ground GND are about equal in size but have opposite signs. So if the Hall voltage is designated as $V_H$ then we have with good approximation $V_{H1} = \frac{1}{2} V_H$ and $V_{H2} = -\frac{1}{2} V_H$. Thus, the second sub-circuit of the constant current source 2 biases the Hall element 10 such that a common mode signal does not occur. This current source may also be used to feed a supply current to an AMR sensor.

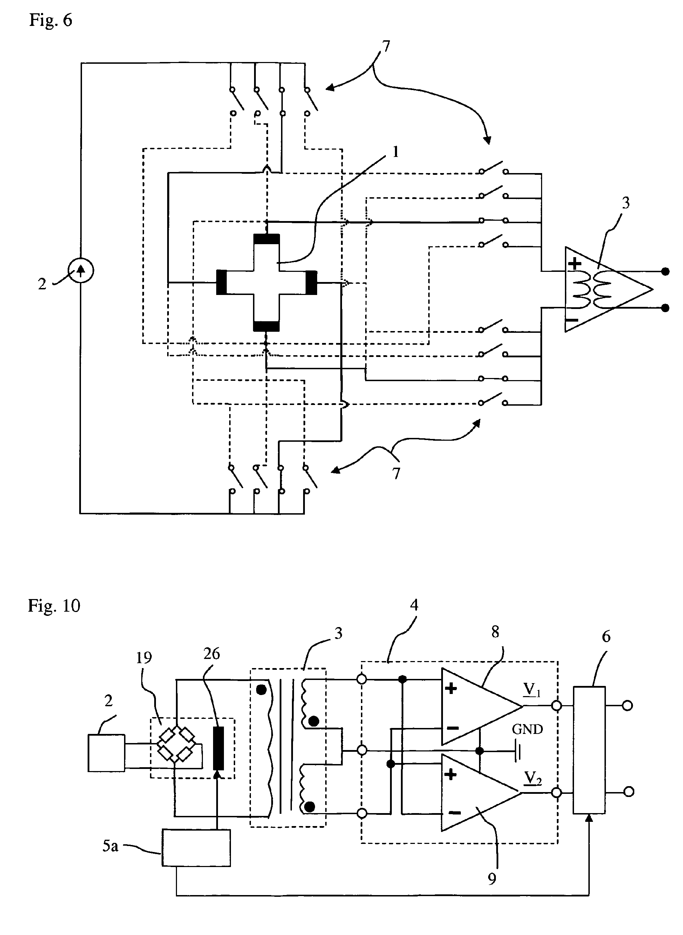

Fig. 10 shows a diagram of a second embodiment of a magnetic transducer according to the invention. In this second embodiment, the magnetic field sensor is an Anisotropic Magneto-Resistive (AMR) sensor 19. The magnetic-field-sensitive part of the AMR sensor 19 consists of four ferromagnetic thin-film resistors connected into a Wheatstone bridge. In addition to the bridge circuit, the AMR sensor 19 comprises further components like an internal set/reset strap 26 or an external coil and corresponding circuitry which allow the polarity of the bridge output voltage to be flipped by applying set and reset current pulses to the set/reset strap 26 or external coil. A set current pulse is defined as a positive current pulse which aligns the magnetic domains of the AMR sensor 19 in a forward easy-axis direction so that the sensor bridge's polarity is positive for positive fields resulting in a positive voltage across the bridge output connections. A reset current pulse is defined as a negative current pulse which aligns the magnetic domains of the AMR sensor 19 in a reverse easy-axis direction so that the sensor bridge's polarity is negative for positive fields resulting in a negative voltage across the bridge output connections.

An AMR sensor is therefore a magnetic field sensor having six terminals, namely two terminals for supplying a supply current to the Wheatstone bridge, two terminals for tapping the output voltage of the Wheatstone bridge, and two terminals for applying the set and reset current pulses to the set/reset strap 26 or external coil. In this sense, the external coil is a part of the AMR sensor. Such an AMR sensor 19 is available for example from Honeywell (sold as HMC1001). The electrical circuitry of the magnetic transducer comprises the same components as the first embodiment and may be realized in any of the different variants shown in Figs. 1 to 3, but the logic block 5 has partially other functions and is therefore configured as a logic block 5a differently from the first embodiment.

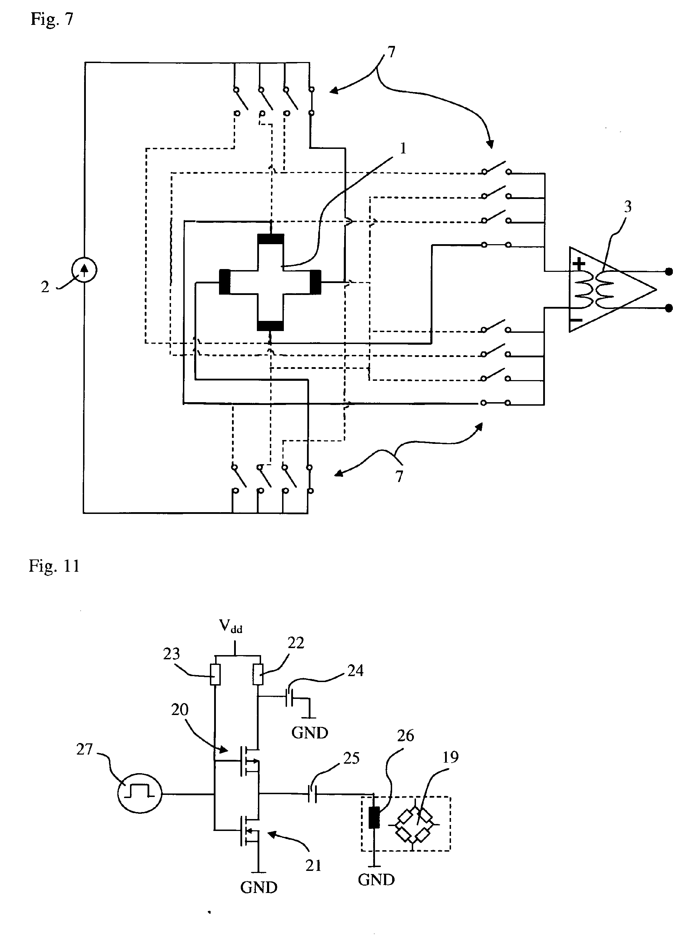

The logic block 5a is configured to produce set and reset pulses according to a predetermined frequency so that the output voltage of the AMR sensor 19 is an AC output signal. The logic block 5a is coupled to the phase sensitive detector 6 and sends a timing or clock signal corresponding to the frequency of the set and reset pulses to the phase sensitive detector 6. Fig. 11 shows an embodiment of a circuit capable of producing set and reset pulses with high peak currents. The circuit comprises two complementary power MOSFETs, namely a p-channel P-MOSFET 20 and an n-channel N-MOSFET 21 (available for example under the trade name IRF7105), two resistors 22, 23 and two capacitors 24, 25. The first resistor 22 and the two power MOSFETs 20, 21 are coupled in series, the two power MOSFETs 20, 21 are coupled as a CMOS (complementary MOS) inverter. The first capacitor 24 connects the node situated between the first resistor 22 and the P-MOSFET 20 with ground. The second capacitor 25 is coupled to a common node of the two power MOSFETs 20, 21 and to the strap 26 or external coil of the AMR sensor 19. The second resistor 23 is coupled to the positive supply voltage $V_{dd}$ and the gates of the power MOSFETs 20, 21. An output of a clock generator 27 is also coupled to the gates of the power MOSFETs 20, 21. Exemplary values are resistor 22 = 220 $\Omega$, resistor 23 = 20 k$\Omega$, capacitor 24 = 10$\mu$F, capacitor 25 = 220 nF. The clock generator 27 delivers pulses of a predetermined frequency. Every change in the pulse level of the generator 27 produces a set or reset pulse: If for a while the output voltage of the clock generator 27 is low, then the N-MOSFET 21 is non-conducting, the P-MOSFET 20 is conducting, so that the capacitor 25 is charged over the resistor 22 and the P-MOSFET 20 to a positive voltage almost equal to $V_{dd}$. When the output voltage of the clock generator 27 goes high, then the P-MOSFET 20 becomes non-conducting, the N-MOSFET 21 becomes conducting, and the capacitor 25 is rapidly discharged over the N-MOSFET 21. The discharging current flows through the strap 26 and produces the reset pulse for the AMR sensor 19. While the output voltage of the clock generator 27 stays high, the P-MOSFET 20 is non-conducting, and the capacitor 24 is charged over the resistor 22 to a positive voltage almost equal to $V_{dd}$. When the output voltage of the clock generator 27 goes low, then the N-MOSFET 21 becomes non-conducting, the P-MOSFET 20 becomes conducting, and the capacitor 25 is rapidly charged from the capacitor 24 over the P-MOSFET 20. The charging current flows through the strap 26 and produces the set pulse for the AMR sensor 19. The duration of a set or reset pulse is relatively short in comparison to the duration of one cycle of the clock signal.

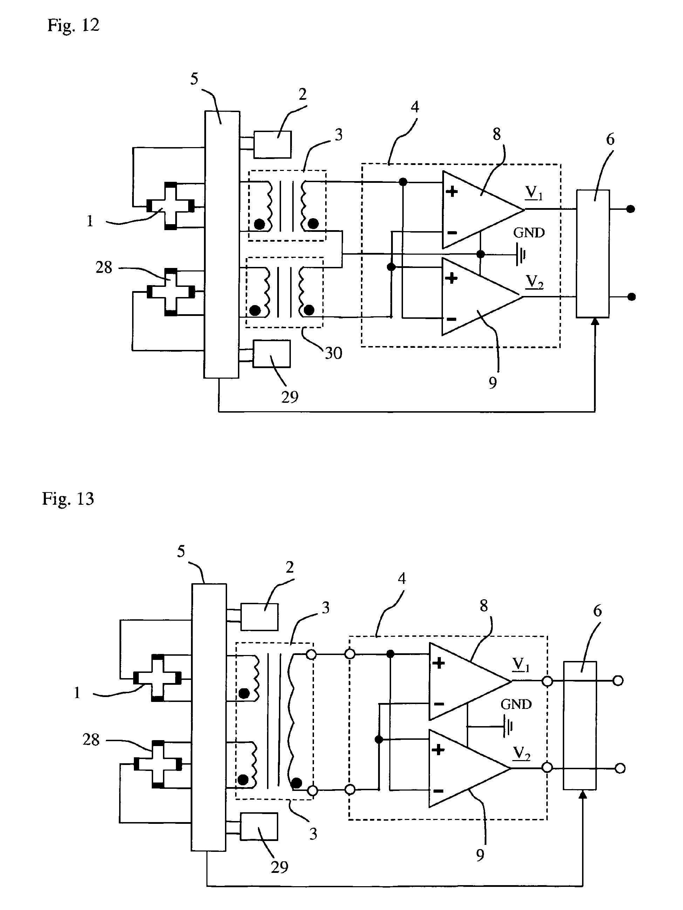

Fig. 12 shows a diagram of a third embodiment of a magnetic transducer according to the invention. In this embodiment, the magnetic transducer comprises two Hall elements 1 and 28, a first current source 2 providing a first supply current to the first Hall element 1 and a second current source 29 providing a second supply current to the second Hall element 28 while the other components of the electrical circuit are essentially the same as in the previous embodiments. In this embodiment, the transformer is composed essentially of two transformers 3 and 30, each having a primary winding with two input terminals and a secondary winding with two output terminals. The logic block 5 couples the first current source 2 and the primary winding of the first transformer 3 to the first Hall element 1 and the second current source 29 and the primary winding of the second transformer 30 to the second Hall element 28 to operate the Hall elements 1, 28 according to the spinning current method, so that the Hall elements 1, 28 each produce an AC output signal. Fig. 13 shows a variant of the third embodiment in which the transformer 3 is formed as a single component having one common magnetic core and only two output terminals, but it may also have a third middle output configured to be coupled to ground GND.

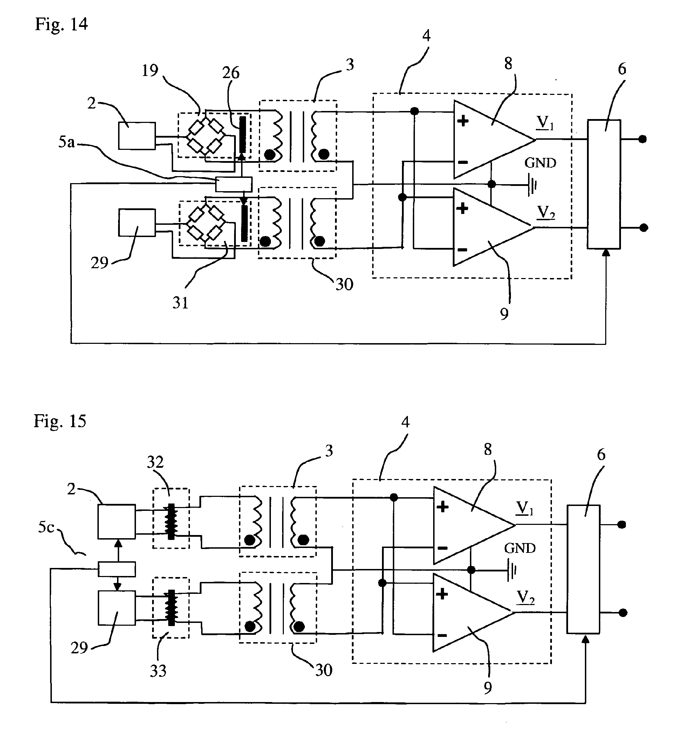

Fig. 14 shows a diagram of a fourth embodiment of a magnetic transducer according to the invention. In this embodiment, the magnetic transducer comprises two AMR sensors 19 and 31 instead of two Hall elements. The AMR sensors 19 and 31 are directly coupled to either the first current source 2 or the second current source 29 and to the primary winding of the first transformer 3 or second transformer 30. The logic block 5a operates the AMR sensors 19 and 31 in the same way as in the second embodiment, i.e. it applies set and reset pulses according to a predetermined frequency to the straps 26 or external coil of the AMR sensors 19 and 31. The transformers 3 and 30 may also be configured in any of the different ways shown in the previous embodiments.

Instead of the Hall element(s) or AMR sensor(s), the magnetic transducer may also comprise any other type of magnetoresistive sensors, like e.g. GMR (giant magnetoresistive sensor) sensor(s), or one or more fluxgate sensors. A fluxgate sensor consists of a small, magnetically susceptible core wrapped by two coils of wire. A current source provides an alternating electrical current having a predetermined frequency which is passed through the first coil, driving the core through an alternating cycle of magnetic saturation; i.e., magnetised, unmagnetised, inversely magnetised, unmagnetised, magnetised, and so forth. This constantly changing magnetization induces an electrical voltage in the second coil, the phase of which depends on the external magnetic field to be measured. Fig. 15 shows a diagram of a fifth embodiment of a magnetic transducer according to the invention. In this embodiment, the magnetic transducer comprises two fluxgate sensors 32 and 33. The first coil of the fluxgate sensor 32 is coupled to the current source 2 and the second coil of the fluxgate sensor 32 is coupled to the primary winding of the first transformer 3. The first coil of the fluxgate sensor 33 is coupled to the current source 29 and the second coil of the fluxgate sensor 32 is coupled to the primary winding of the second transformer 30. The logic block 5c comprises a clock generator which controls the frequency of the current source's 2 output. The phase-sensitive detector 6 operates as a synchron demodulator. The magnetic transducer shown in Fig. 15 comprises two fluxgate sensors. However, a magnetic transducer having only one fluxgate sensor may also be formed in analogy with the previously shown embodiments.

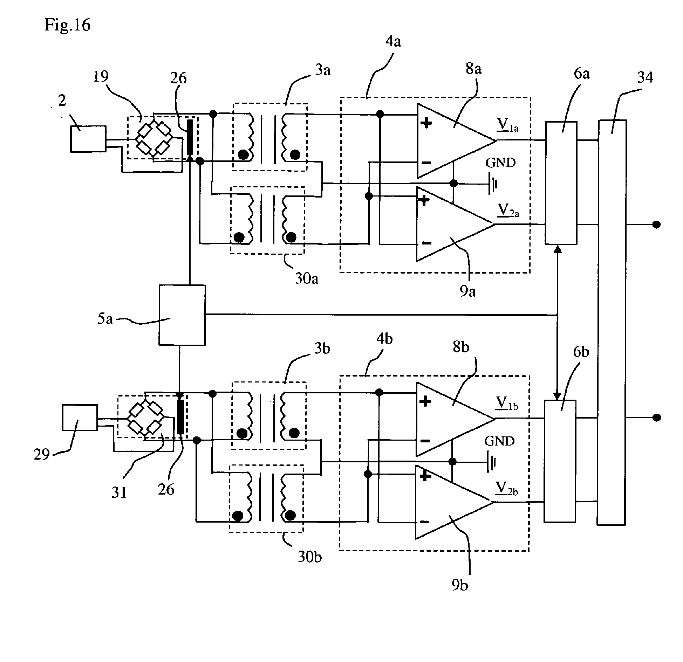

Fig. 16 shows a diagram of a sixth embodiment of a magnetic transducer according to the invention. In this embodiment, the magnetic field sensors are AMR sensors. The AMR sensor 19 is coupled to a first amplification chain comprising the same components as in the previous embodiments and labelled with the literal "a", the AMR sensor 31 is coupled to a second amplification chain comprising the same components as in the previous embodiments and labelled with the literal "b". The outputs of the phase sensitive detectors 6a and 6b are coupled to a voltmeter 34 or to an analog to digital converter. However, the transformers may be configured as in any of the previous embodiments. The magnetic field sensors could also be Hall elements or fluxgate sensors in which cases the logic block 5a would have to be modified for Hall elements or fluxgate sensors as shown above.

In all embodiments with two sensors of any kind, it is preferred to have one transformer having one single magnetic core, two primary windings and one secondary winding (like in Fig. 13) or possibly two secondary windings, although two separate transformers as shown in some of the embodiments are also possible. The reason is that the difference or sum of the two sensor signals should preferably be made as early in the signal chain as possible, which is therefore best done in the transformer core (at the magnetic flux level).

The magnetic transducer of the present invention may be used in various applications. If the magnetic transducer comprises two magnetic field sensors, it may be used for example as magnetic gradiometer. A magnetic gradiometer measures the gradient of the magnetic field. In an axial gradiometer, the two magnetic field sensors of the magnetic transducer are placed above each other on a common axis. The result coming from the magnetic transducer is the difference in magnetic flux density at that point in space which corresponds to the first spatial derivative. In a planar gradiometer, the two magnetic field sensors are placed next to each other. The magnetic transducer may also be used as a current transducer in that it measures the strength of the magnetic field produced by a current flowing through a conductor. In this case, the current transducer preferably comprises a magnetic circuit having at least one air gap in which the magnetic field sensor(s) of the magnetic transducer are placed. Such a current transducer may be formed as a clamp-on current transducer or ammeter.

In any application using two magnetic field sensors, the coupling of the second magnetic field sensor to the associated transformer can be done as shown in the various embodiments if the direction of the magnetic field to be measured is the same for both magnetic field sensors. If the direction of the magnetic field at the places of the two magnetic field sensors runs in opposite directions, then the polarity of the output signal of the second magnetic field sensor is reversed with respect to the polarity of the output signal of the first magnetic field sensor. In this case either the input current or the output voltage of one of the two magnetic field sensors needs to be inverted (which can be done for example by changing the coupling scheme to the current source or to the transformer or by modifying the winding direction of the transformer).

In the following embodiments and illustrations, for illustration purposes the magnetic field sensor(s) used in the magnetic transducers are Hall element(s), but the magnetic field sensors may also be AMR or fluxgate sensor(s). A magnetic transducer as used in the following comprises one or more magnetic field sensor(s) and electrical circuitry to operate the magnetic field sensor(s).

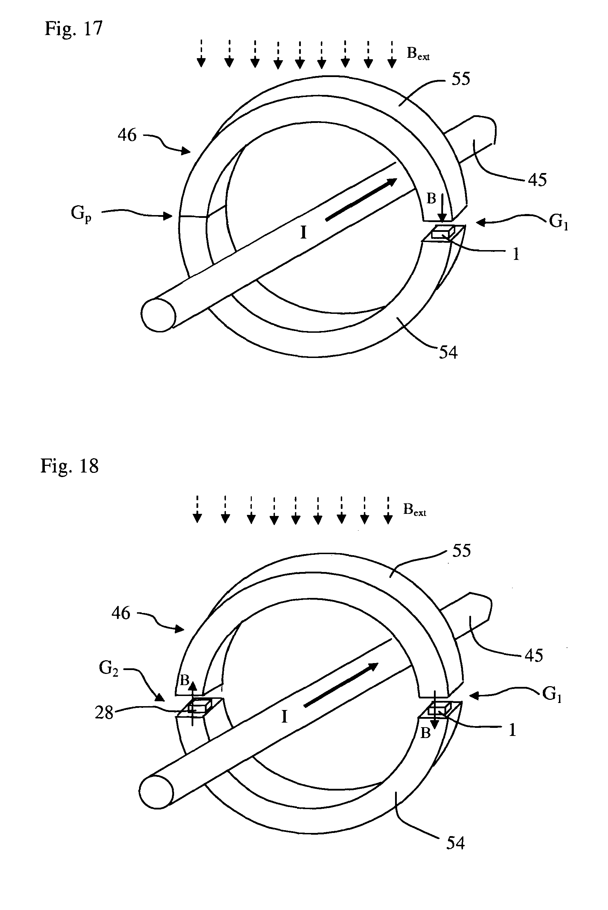

Fig. 17 shows a schematic view of the principal mechanical configuration of a current transducer according to the state of the art. The current transducer comprises a ring-shaped ferromagnetic core 46 with an air gap $G_1$, in which the magnetic field sensor, e.g. a Hall element 1, of the magnetic transducer is placed. The core 46 encloses a cable 45, in which a current I flows which is to be measured. In a clamp-on current transducer, the core 46 consists of at least two approximately equal half-circular pieces 54 and 55, which can be assembled (clamped) around the cable 45. In the present embodiment , there are two air gaps $G_1$, $G_p$ between the pieces 54 and 55 of the core 46. While the air gap $G_1$ is used to receive the magnetic field sensor, the air gap $G_p$ is a parasitic one, which exists because of imperfections of the surfaces of the pieces 54 and 55 of the core 46, which touch each other. In a current transducer designed for permanent and non clamp-on use, the ferromagnetic core 46 is usually made of one piece, and the parasitic air gap $G_p$ does not exist. A current I flowing through the cable 45 produces a magnetic field B in the air gap $G_1$, which is measured by the magnetic field sensor of the magnetic transducer. The output signal of the magnetic transducer is proportional to the current I. The proportionality factor is called the sensitivity of the current transducer.

There are two major deficiencies of such a current transducer. One deficiency is a dependence of its sensitivity on the position of the enclosed cable 45 within the core 46. For example, if the cable 45 moves from the center of the core 46 toward the air gap $G_1$, then the

magnetic sensor will be exposed to a stronger magnetic field associated with the current I, and the current measured by the current transducer will appear stronger. The other deficiency is a dependence of the output signal of the current transducer on an external magnetic field. For example, with reference to Fig. 17, an external magnetic field $B_{ext}$ having the same direction as the internal magnetic field B will produce in the air gap $G_1$ a parasitic magnetic field $B_{par}$. The parasitic magnetic field $B_{par}$ cannot be distinguished from the internal magnetic field B, which should be measured. For a core made of a very high-permeability material and with very small air gaps, the parasitic magnetic field $B_{par}$ is approximately given by the following equation:

$$B_{par} \approx D_{ext}^2 / (a \times b) \times (g_p / g_1) \times B_{ext}$$

Here $D_{ext}$ denotes the external diameter of the core 46, a and b are the dimensions of the rectangular cross-section of the core 46, and $g_1$ and $g_p$ are the thicknesses of the air gaps $G_1$ and $G_p$, respectively. The term $D_{ext}^2 / (a \times b)$ comes from the effect of the concentration of the external magnetic flux into the core 46. This will be further referred to as the magnetoconcentration effect. The term $(g_p / g_1)$ represents the sharing ratio of the concentrated magnetic flux among the two air gaps $G_1$ and $G_p$.

When the structure shown in Fig. 17 is used in a clamp-on current transducer, it shows a third major deficiency, which is a poor repeatability of the sensitivity after repeated clamping-on and off of the core 46. This comes from the fact that the sensitivity of the current transducer is proportional to the factor $1 / (g_1 + g_p)$; and it is very difficult to achieve the mechanical precision of the clamping-on mechanism, which will insure the repeatability of the sum $(g_1 + g_p)$ better than a few percent.

A known attempt to mitigate the first two deficiencies is illustrated in Fig. 18. The core 46 of the transducer consists of two half-circular parts 54 and 55 of approximately equal size, having between them two equal air gaps $G_1$, $G_2$, and in each of the gaps there is a magnetic field sensor, e.g. as shown a Hall element 1 or 28. Such a structure is more robust with respect to the positioning of the cable 45. But in order to suppress the parasitic influence of the external magnetic field a perfect symmetry of the systems gap $G_1$ - Hall 1 and gap $G_2$ - Hall 2 is required, which is difficult to achieve, particularly in a clamp-on version of the current transducer. Moreover, in the case of a clamp-on transducer, this structure also suffers from poor repeatability.

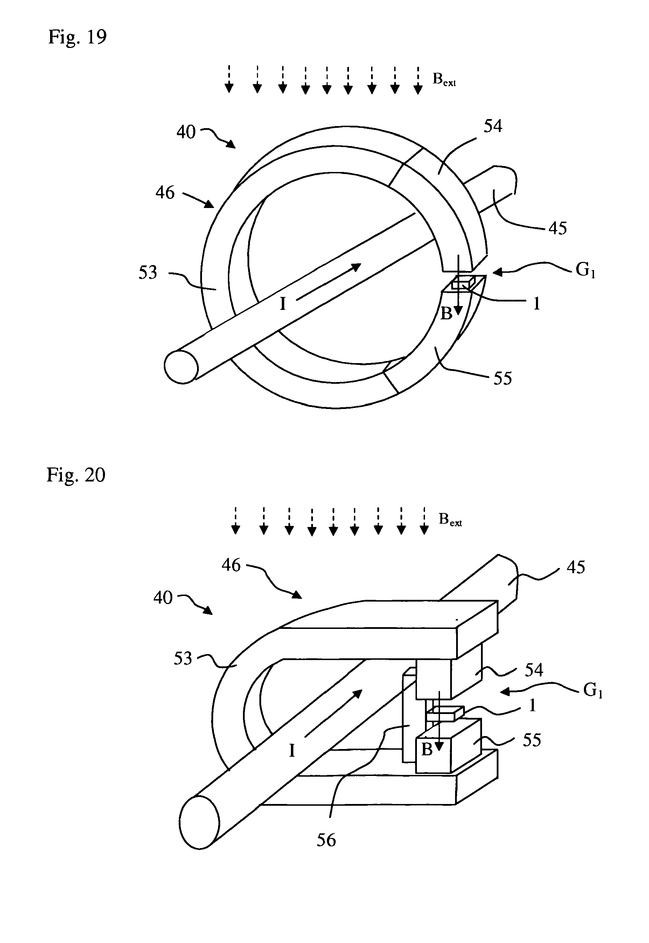

Fig. 19 shows a first embodiment of a measurement head 40 of a current transducer. The head 40 has an approximately circular core 46 consisting of three ferromagnetic pieces 54 to 53. The piece 53 has the form of an arc longer than a half-circle. The two pieces 54 and 55 are arcs shorter than 1/4 of a circle. The contact surfaces between the pieces 53 and 51 and between the pieces 53 and 52 are approximately parallel with each other. The consequences of these measures are as follows:

- The form of the ferromagnetic piece 53 looks like the character C. This results in the fact that an external magnetic flux $\Phi_{ext}$, caused by the external magnetic field $B_{ext}$, is channeled to the side of the magnetic core 46, which has no air gap (which is the left side in Fig. 19). Put otherwise, the piece 53 shields the Hall element 1 from the external magnetic field $B_{ext}$; such a core, with a C-shaped piece 53, has a self-shielding effect.

- The two pieces 54 and 55 can be rigidly connected to each other (by non-magnetic means which are not shown), but with the air gap $G_1$ formed between them and the magnetic field sensor placed in the air gap $G_1$. This solution allows the disassembly of the head into two parts at a location other than the air gap $G_1$ so that the width of the air gap $G_1$ always remains the same and is thus independent from any mechanical alignment errors when the head is re-assembled.

- The areas of the two parasitic air gaps $G_{p1}$ and $G_{p2}$ at the contact surfaces between the pieces 53 and 54 and between the pieces 53 and 55, respectively, are preferably much larger than in the case shown in Fig. 19. This also results in a better repeatability of the clamp-on operations.

- If the arc of the piece 53 is not longer than a half-circle, then the clamp-on clearance of the core 46 reaches its maximum which is as large as the inner diameter of the core 46.

Fig. 20 shows a variation of the embodiment shown in Fig. 19 where the piece 53 of the core 46 has a U-shape that completely encloses the current-carrying cable 45 on three sides. The pieces 54, 55 are short and approximately straight. This solution offers further improved immunity to external magnetic fields, since an external magnetic flux passes preferentially through the round part of the piece 53 and so circumvents the magnetic field sensor. Put otherwise, such a core 46, with a U-shaped piece 53, has a strong self-shielding effect. The pieces 54, 55 are rigidly connected to each other by non-magnetic means 56 such as to form the air gap $G_1$ between them and the magnetic field sensor is placed in the air gap $G_1$.

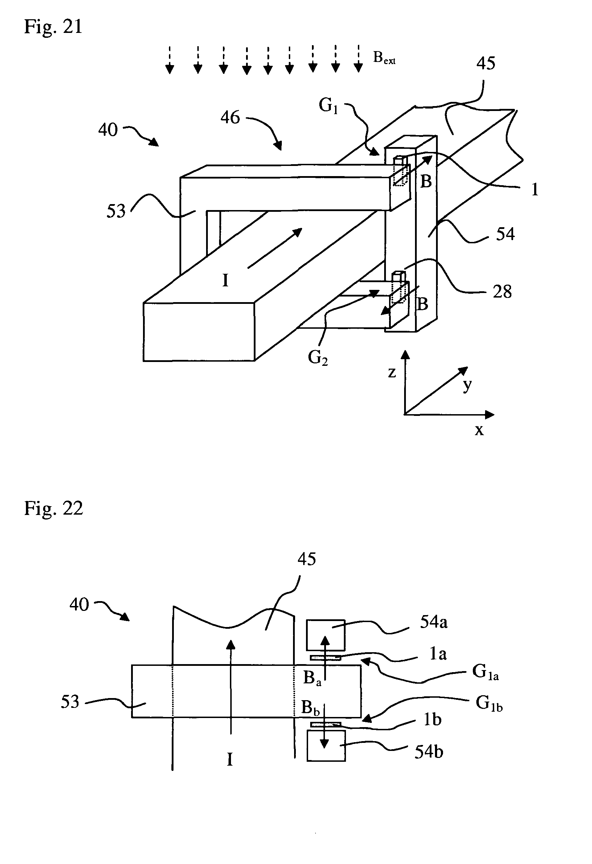

Fig. 21 shows an embodiment where the core 46 is composed of two pieces 54 and 55, the first piece 53 having a U-shape and the piece 54 being a straight piece. The shape and/or the cross-section of the U-shaped piece 53 is rectangular, for example. The piece 54 is positioned on one side of the legs of the U-shaped piece 53 so that the part of the magnetic circuit having the air gaps $G_1$, $G_2$ is rotated by 90° with respect to the U-shaped piece 53. Therefore, the magnetic field B produced by the current I flowing in the enclosed cable 45 points in a direction parallel with the longitudinal axis of the cable 45 at the positions of the Hall elements 1 and 28 (which is the y-axis in the shown co-ordinate system). This structure is self-shielded by the pieces 53, 54 from the x- and z-components of an external magnetic field $B_{ext}$. Only the y-component of an external magnetic field is "seen" by the Hall elements 1 and 28. But the pieces 53, 54 of the ferromagnetic core 46 are short in the y-direction, so that the magnetoconcentration effect in that direction is the smallest. Moreover, since the directions of the magnetic field B produced by the current I are opposite in the two Hall elements 1 and 28, and the directions of the y-component of an external field $B_{ext}$ are the same, the signals due to the external magnetic field $B_{ext}$ can be cancelled. Therefore, this solution offers a further improved immunity to external magnetic fields, particularly to the magnetic fields produced by other cables positioned parallel with the cable 45 which do not have a substantial y-component.

Fig. 22 shows a top view of a variation of the embodiment of Fig. 21 where there are two straight pieces 54a, 54b positioned at the opposite sides of the legs of the piece 53 of the core 46, so that four air gaps (only two air gaps $G_{1a}$, $G_{1b}$ are visible) are formed, each having one Hall element 1a or 1b, 28a, 28b (not visible). Since the direction of the magnetic fields $B_a$, $B_b$ produced by the current I are opposite in the Hall elements 1a, 1b, and the directions of the y-component of an external field $B_{ext}$ are the same, the signals due to the external magnetic field can be cancelled. Therefore, this solution offers still further improved immunity to external magnetic fields independently on its direction. Moreover, due to the symmetry of the positions of the Hall elements 1a or 1b, 28a, 28b with respect to the piece 53 of the core 46, the repeatability of the clamping-on operation is much improved. With this solution, the two pieces 54, 55 are arranged symmetrically with respect to a symmetry plane of the piece 53 on opposite sides of the piece 53.

A plurality of heads of a current transducer as those illustrated in Figs. 19 to 22 may be used in parallel. The heads are positioned approximately parallel to each other along the axis of the cable 45. Each of the heads may be rotated around the axis of the cable 45 for an individual or the same angle, for example for an angle of 90° or 180°. The magnetic sensors of the heads can be operated in parallel. Alternatively, each magnetic sensor, or a pair of magnetic sensors, may be connected to a separate electronic circuit to build several magnetic transducers; and the signal outputs of all the magnetic transducers are summed up, and this sum of the signals represents the output signal of the whole current transducer system. In comparison with individual current transducers shown in Figs. 19 to 22, this solution offers a better signal to noise ratio, improved immunity to external magnetic fields, and lower sensitivity to the position of the enclosed current-carrying cable 45.

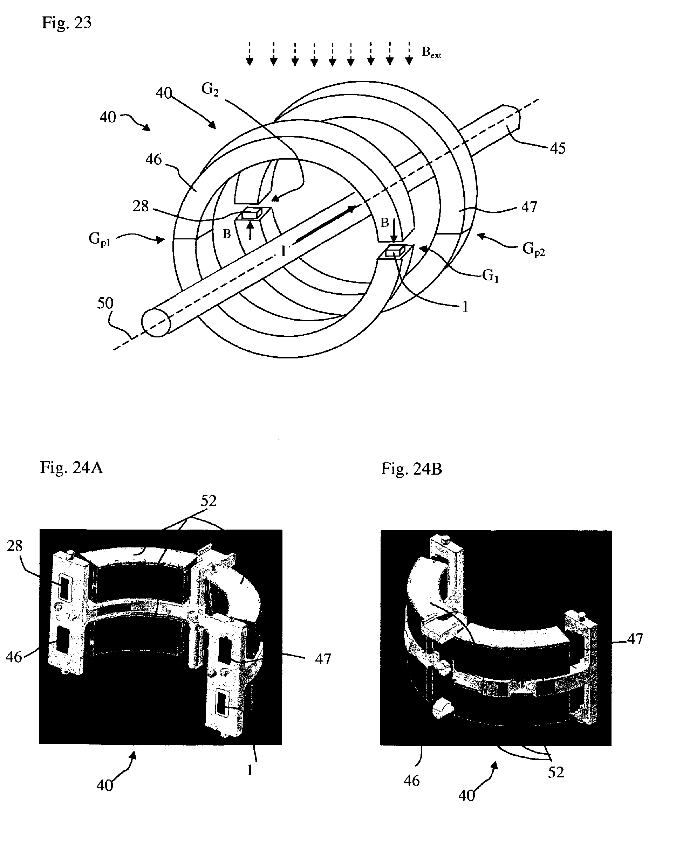

Fig. 23 shows an example of the head 40 of a current transducer composed of two core-structures like those shown in Fig. 17. The two core-structures are positioned approximately parallel to each other along an axis 50 and spaced by a predetermined distance from each other along the axis 50. The cable 45 runs along the axis 50. The second core 47 is rotated around the axis of the cable 45 for an angle of approximately 180° with respect to the first core 46.

The head 40 of Fig. 23 comprises two ferromagnetic cores 46 and 47 forming two magnetic circuits each having an air gap $G_1$ or $G_2$, respectively, and having a parasitic air gap $G_{1p}$ or $G_{2p}$, respectively. The cores 46, 47 are placed at a distance from each other along the direction of the cable 45. A first Hall element 1 is placed in the air gap of the first core 46, a second Hall element 28 is placed in the air gap of the second core 47. A current flowing through the cable 45 produces a magnetic field B. The air gaps $G_1$ and $G_2$ of the two cores 46, 47 are situated preferably at diametrically opposite sides with respect to a center axis 50 so that the magnetic field B produced by the current I flowing in the cable 45 points in opposite directions at the places of the Hall elements 1 and 28 (illustrated by arrows pointing in opposite directions). The difference of the output signals of the two Hall elements 1 and 28 is therefore independent from an external magnetic field $B_{ext}$ which may be present. The ferromagnetic cores 46 and 47 shown in Fig. 23 can easily be substituted by any of the cores shown in Figs. 19 to 22. Moreover, additional such cores can be added. This brings about further improvements in immunity to external magnetic fields and signal to noise ratio, lower sensitivity to the position of the enclosed current-carrying cable 45, and better repeatability.

For use in a clamp-on application, e.g. in a clamp-on ammeter, the head 40 is mechanically comprised of at least two parts that are detachable from each other such that it is possible to mount the head 40 around the cable 45. This means that the cores 46, 47 consist each of at least two ferromagnetic pieces. Figs. 24A and 24B show the two parts of the head 40 according to a preferred embodiment in which each of the cores 46, 47 comprises two ferromagnetic core halves of a half-circular shape and about the same size. The two parts of the head 40 each comprise a basic body on which the core halves are mounted in a floating manner and springs are provided to ensure a reproducible contact between the core halves. The first Hall element 1 is mounted on an end of a core half of the core 46, the second Hall element 28 is mounted on an end of a core half of the core 47 of the same head part, and as can be seen on opposite lying ends of the core halves. When the two parts of the head 40 are assembled, a first end of the first core half and a first end of the second core half of the core 46 are in contact with each other while the second end of the first core half and the second end of the second core half are separated by the air gap. The same holds for core 47. The Hall elements 1, 28 are each bordered by a protruding frame or another distance keeping means that defines the width of the respective air gap in the assembled condition of the head 40. The basic bodies of the two parts have self-aligning means, e.g. a pin and a conical opening receiving the pin, and springs to generate an attracting, resilient force between the two parts in the connected state. This ensures on the one hand side that the first ends of the core halves are reproducibly contacted and on the other hand side that the width of the air gaps is always the same when the two parts of the head 40 are clamped around the cable 45.

For use in applications, where the head 40 does not need to be detachable, the ferromagnetic cores 46, 47 may be composed of as less ferromagnetic pieces as possible in order to avoid any parasitic air gap.

The material of the ferromagnetic cores 46, 47 must have a high relative permeability of at least 1000 because a high relative permeability helps to shield the Hall elements 1, 28 from any possible environmental magnetic field. Moreover, the ferromagnetic cores 46, 47 should ideally have no remanent field. Since this is difficult to achieve, the ferromagnetic cores 46, 47 should be easily demagnetizable. For this purpose, coils 52 are wound on each of the four core halves and the head 40 is provided with the necessary electronic circuitry to operate the coils 52 in a demagnetization mode to demagnetize the ferromagnetic cores 46, 47. The classical method to demagnetize a core is to magnetize it several times in opposite directions with decreasing excitations. This can be done for example with a resonant circuit comprising the coils 52 and a capacitor by linearly increasing the frequency of the current flowing through the resonant circuit until the resonant frequency of the resonant circuit is reached, staying there a few periods and then exponentially reducing the current.

The clamp-on ammeters may be operated in the so-called open loop mode or in the closed loop mode. In the latter, the coils 52 are supplied during a measurement with a coil current that creates in the air gap of the respective magnetic core a magnetic field opposite to the magnetic field created by the current flowing through the cable 45. The strength of the coil current is adjusted such that the Hall voltage of the Hall element placed in the respective air gap is equal to zero.

In all these embodiments of the head 40, the head 40 may also have a second and/or third, etc., Hall element placed in the air gap adjacent to the Hall element 1. The use of the additional Hall element(s) increases the signal to noise ratio. Furthermore, as illustrated in several figures, the shape of the ferromagnetic cores 46 and 47 is not limited to the toroidal shape. The ferromagnetic core(s) may have any other suitable shape, for example a rectangular shape or D-shape.

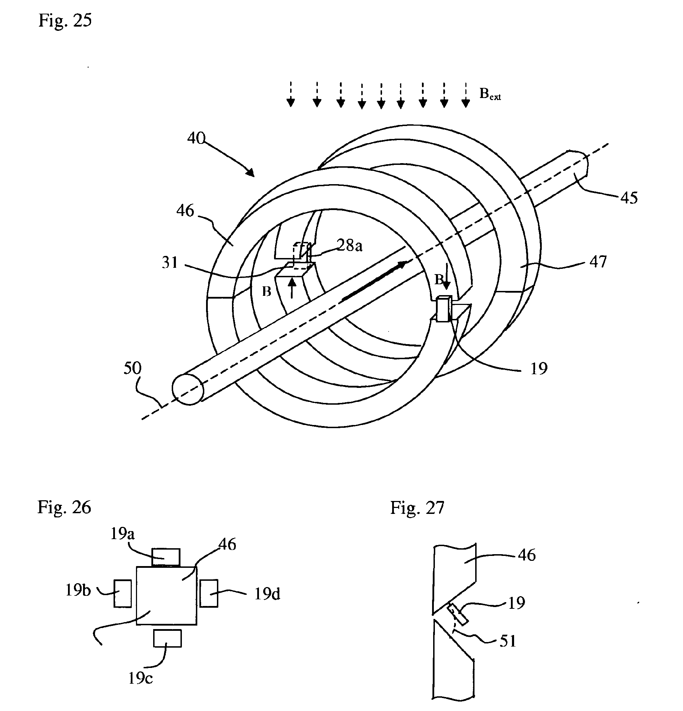

The Hall element(s) may be replaced with AMR (anisotropic magnetoresistive sensor) sensor(s) or GMR sensor(s) or fluxgate sensor(s) or any other suitable magnetic field sensor(s). Fig. 25 shows an embodiment of such a head 40 with AMR sensors 19, 31. As the AMR sensors 19, 31 are usually sensitive to a direction of the magnetic field running parallel to the upper surface of their IC housing, they are preferably not placed in the air gaps of the ferromagnetic cores 46, 47 but adjacent the air gaps so that the air gaps can be kept small. The AMR sensors 19, 31 therefore lie in the stray magnetic field surrounding the space near the air gaps. As shown in fig. 26 in a top view for core 46, this may allow four AMR sensors 19a to 19d to be mounted at the four edges limiting the face of the cores 46, 47 facing the air gap. The four AMR sensors 19a to 19d may be coupled in parallel and operated like one AMR sensor. Fig. 27 shows yet another way to mount an AMR sensor. In this case, the end faces of the core 46 do not extend parallel to each other, but include an angle so that the housing of the AMR sensor 19 finds enough room in the air gap between the end faces. The housing of the AMR sensor 19 is oriented in the proper way to align the AMR sensor 19 with the magnetic field lines 51 in the air gap which leave the end faces of the core 46 almost perpendicularly and are therefore curved. The AMR sensors may be replaced by GMR sensors.

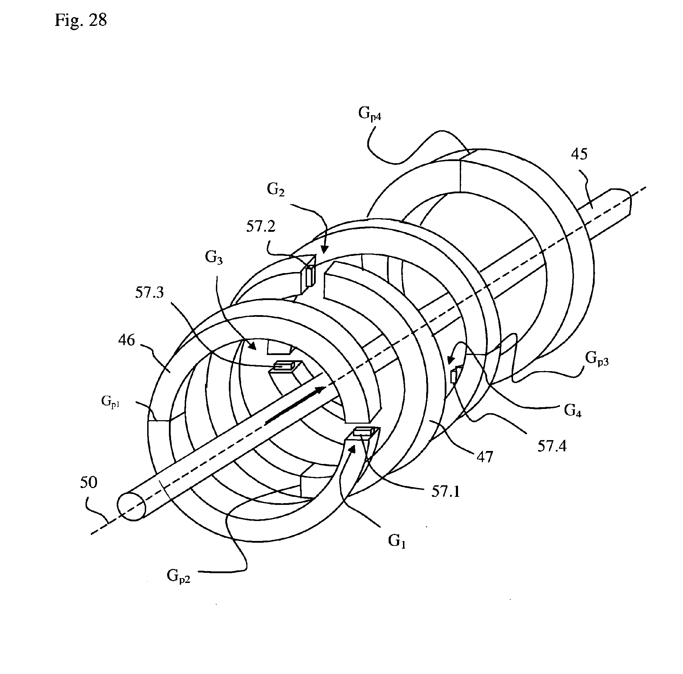

Fig. 28 which for reasons of clarity is not drawn true to scale shows an embodiment where the head 40 comprises four almost identical ferromagnetic cores 46, 47, 48 and 49, each ferromagnetic core forming a magnetic circuit having an air gap $G_1$ or $G_2$ or $G_3$ or $G_4$, respectively, and a magnetic field sensor 57.1 to 57.4 (e.g. Hall elements, AMR or GMR sensors, or fluxgate sensors, or any other suitable magnetic field sensor) placed at the air gap. The ferromagnetic cores 46, 47, 48 and 49 may consist of one ferromagnetic piece, or as shown, of two ferromagnetic pieces so that the ferromagnetic cores 46, 47, 48 and 49 can be easily clamped on and detached from the cable 45. In the latter case, parasitic air gaps $G_{p1}$ or $G_{p2}$ or $G_{p3}$ or $G_{p4}$ exist between the two pieces of a core. The ferromagnetic cores 46, 47, 48 and 49 are positioned approximately parallel to each other and spaced by a predetermined distance from each other along an axis 50 and rotated by a predetermined angle of rotation around the axis 50 with respect to each other, so that the air gaps $G_1$, $G_2$, $G_3$ and $G_4$ of the ferromagnetic cores 46, 47, 48 and 49 are situated at different angles. In the embodiment shown in Fig. 28, the angle of rotation is approximately 90°. The head 40 may comprise any number of ferromagnetic cores, e.g. 2, 3, 4 or more. The preferred angle of rotation is approximately 360°/(number of ferromagnetic cores), but any other angle of rotation may also be chosen. The individual ferromagnetic cores may be rotated with respect to their neighbor core(s) about any arbitrary individual angle of rotation.

With the head 40 the magnetic field sensor(s) is/are placed at the air gap which means that Hall elements are preferably placed in the air gaps, AMR sensors, flux-gate sensors, and magnetoimpedance sensors are preferably placed adjacent the air gaps. But there are Hall magnetic sensors (such as vertical Hall or Hall combined with planar magnetic concentrators), which are sensitive to an in-the-chip-plane component of the magnetic field; such a Hall sensor should also be placed adjacent the air gap. Also, there are AMR magnetic sensors (such as Honeywell type HMC 1051z), which are sensitive to an orthogonal-to-the-chip-plane component of the magnetic field; such an AMR sensor should be placed in the air gap.

The system described above with each head 40 having two cores 46 and 47 and two Hall elements 1, 28 is capable of detecting a leakage current down to approximately 1 μA (microampere). If a system is used with which each head 40 has only one ferromagnetic core 46 with an air gap and one magnetic field sensor placed in the air gap or besides the air gap in the stray magnetic field then a leakage current down to the order of 100 μA can be detected. Fig. 17 shows a schematic view of the principal mechanical configuration of such a head 40 having one magnetic field sensor only, in this case a Hall element 1.

The current transducer according to the invention provides several features and advantages:

- Several measures contribute to the cancellation of the common mode signal, among them in particular the use of two ferromagnetic cores with two Hall elements or AMR or fluxgate or magnetoimpedance sensors per head, the design of the electronic circuit for full differential operation, the magnetic field sensor biasing method providing the output voltage at the terminals of the magnetic field sensor as voltages of equal size but opposite sign with respect to ground, the transformer coupling between the magnetic field sensors and the preamplifier.

- The transformer coupling of the voltage terminals of the magnetic field sensor to the preamplifier allows the electronic circuit to achieve an equivalent input noise very close to the thermal noise of the resistance of the magnetic field sensor.

- The electronic circuit operates in full differential mode. The operation of each ammeter is analogous to the operation of a differential amplifier, where the useful magnetic field corresponds to a differential voltage and an external magnetic field corresponds to a common mode voltage which allows an effective separation of the wanted magnetic field from external magnetic fields.

- The use of two ore more ferromagnetic cores results in a significant reduction of the influence of external magnetic fields and therefore increases the sensitivity of the current transducer.

In some applications, the head may be equipped with any suitable magnetic field sensor that is small enough to fit in the air gap of the respective ferromagnetic core. In applications, where the output signal of the magnetic field sensor is coupled to a transformer, the magnetic field sensor must be of a type that can be modulated to produce an alternating voltage or current output signal, as has been shown above for the Hall-effect, AMR and fluxgate sensors.

While embodiments and applications of this invention have been shown and described, it would be apparent to those skilled in the art having the benefit of this disclosure that many more modifications than mentioned above are possible without departing from the inventive concepts herein.

**Claims**

1. Current transducer for measuring a current flowing through a cable (45), the current transducer comprising a head (40) comprising at least two ferromagnetic cores (46, 47, 48, 49) enclosing the cable (45), each core (46, 47, 48, 49) having an air gap ($G_1$, $G_2$, $G_3$, $G_4$) and a magnetic field sensor (57) placed at the air gap, wherein the ferromagnetic cores (46, 47, 48, 49) are positioned approximately parallel to each other and spaced by a predetermined distance from each other along an axis (50) and rotated by a predetermined angle of rotation around the axis (50) with respect to each other, so that the air gaps ($G_1$, $G_2$) of the ferromagnetic cores (46, 47, 48, 49) are situated at different angles.

2. Current transducer according to claim 1, wherein the number of the ferromagnetic cores (46, 47) of the head (40) is two and the predetermined angle of rotation is approximately 180°, so that the air gaps ($G_1$, $G_2$, $G_3$, $G_4$) of the two ferromagnetic cores (46, 47) are situated at diametrically opposite sides with respect to the axis (50).

3. Current transducer according to claim 1, wherein the number of the ferromagnetic cores (46, 47, 48, 49) of the head (40) is four and the predetermined angle of rotation is approximately 90°, so that the air gaps ($G_1$, $G_2$, $G_3$, $G_4$) of the four ferromagnetic cores (46, 47, 48, 49) are mutually rotated for an angle of approximately 90°.

4. Current transducer according to any of claims 1 to 3, wherein each ferromagnetic core (46, 47, 48, 49) is composed of at least two pieces, so that the ferromagnetic cores can be assembled around the cable (45) without disconnecting the cable.

5. Current transducer according to any of claims 1 to 4, wherein the magnetic field sensors are Hall devices (1, 28), which are placed within or adjacent the air gaps ($G_1$, $G_2$, $G_3$, $G_4$) of the ferromagnetic cores (46, 47, 48, 49).

6. Current transducer according to any of claims 1 to 4, wherein the magnetic field sensors are magnetoresistive sensors (19, 31), which are placed adjacent or within the air gaps ($G_1$, $G_2$) of the ferromagnetic cores (46, 47).

7. Current transducer according to any of claims 1 to 6, further comprising
a transformer (3) coupled to the magnetic field sensor(s),
a fully differential preamplifier (4) coupled to the transformer (3),
a phase sensitive detector (6) coupled to the preamplifier (4), and
a logic block (5) configured to operate the magnetic field sensors to provide an AC output signal.

8. Current transducer according to any of claims 1 to 4, further comprising
a transformer (3) comprising two input terminals and two output terminals,
a fully differential preamplifier (4) comprising two input terminals and two output terminals, the two input terminals coupled to said two output terminals of the transformer (3),
a phase sensitive detector (6) comprising two input terminals coupled to the output terminals of the preamplifier (4) and providing a DC output voltage, and
a logic block (5, 5a) configured to operate the magnetic field sensor to provide an AC output voltage, wherein
each magnetic field sensor is a Hall element (1) comprising four terminals serving to receive a supply current and to deliver an output voltage and the logic block (5) comprises circuitry to couple the Hall element (1) to a current source (2) and to the input terminals of the transformer (3) according to a predetermined spinning current scheme, or wherein
each magnetic field sensor is an AMR sensor (19) comprising four terminals serving to receive a supply current and to deliver an output voltage and two terminals serving to receive set and reset current pulses that change the polarity of the output voltage, wherein the terminals serving to receive a supply current are coupled to a current source (2), the terminals serving to deliver an output voltage are coupled to the input terminals of the transformer (3), and the terminals serving to receive set and reset current pulses are coupled to the logic block (5), and the logic block (5) comprises circuitry to deliver set and reset current pulses according to a predetermined frequency, or wherein
each magnetic field sensor is a fluxgate sensor comprising four terminals serving to receive an excitation current and to deliver an output voltage, wherein the terminals serving to receive the excitation current are coupled to a current source (2) and the terminals serving to deliver an output voltage are coupled to the input terminals of the transformer (3), wherein the logic block (5c) comprises circuitry to control the current source (2) to provide the supply current as an AC current having a predetermined frequency.

9. Current transducer according to any of claims 1 to 8, further comprising one or more coils (52) wound around the ferromagnetic cores (46; 47) and electronic circuitry configured to temporarily supply a current through the one or more coils (52) to demagnetize the ferromagnetic cores (46; 47).

10. Current transducer according to claim 9, wherein a separate coil is wound around each ferromagnetic core, the current transducer further comprising electronic circuitry configured to supply a separate current through each of the coils (52) for operating each of the magnetic field sensors in a closed-loop mode.

11. Current transducer according to any of claims 1 to 8, further comprising a separate coil (52) wound around each ferromagnetic core (46; 47) and electronic circuitry configured to supply a separate current through each of the coils (52) for operating each of the magnetic field sensors in a closed-loop mode.

**Patentansprüche**

1. Stromwandler zum Messen eines durch ein Kabel (45) fliessenden Stroms, umfassend einen Kopf (40), der wenigstens zwei ferromagnetische Kerne (46, 47, 48, 49) umfasst, die das Kabel (45) umschliessen, wobei jeder Kern (46, 47, 48, 49) einen Luftspalt ($G_1$, $G_2$, $G_3$, $G_4$) und einen bei dem Luftspalt platzierten Magnetfeldsensor (57) aufweist, wobei die ferromagnetischen Kerne (46, 47, 48, 49) annähernd parallel zueinander und entlang einer Achse (50) um eine vorbestimmte Distanz voneinander beabstandet positioniert und relativ zueinander um einen vorbestimmten Drehwinkel um die Achse (50) rotiert sind, so dass die Luftspalte ($G_1$, $G_2$) der ferromagnetischen Kerne (46, 47, 48, 49) bei unterschiedlichen Winkeln angeordnet sind.

2. Stromwandler nach Anspruch 1, wobei die Anzahl der ferromagnetischen Kerne (46, 47) des Kopfes (40) zwei beträgt und der vorbestimmte Drehwinkel ungefähr 180° beträgt, so dass die Luftspalte ($G_1$, $G_2$, $G_3$, $G_4$) der beiden ferromagnetischen Kerne (46, 47) auf einander bezüglich der Achse (50) diametral gegenüberliegenden Seiten angeordnet sind.

3. Stromwandler nach Anspruch 1, wobei die Anzahl der ferromagnetischen Kerne (46, 47, 48, 49) des Kopfes (40) vier beträgt und der vorbestimmte Drehwinkel ungefähr 90° beträgt, so dass die Luftspalte ($G_1$, $G_2$, $G_3$, $G_4$) der vier ferromagnetischen Kerne (46, 47, 48, 49) gegenseitig um einen Winkel von etwa 90° gedreht sind.

4. Stromwandler nach einem der Ansprüche 1 bis 3, wobei jeder ferromagnetische Kern (46, 47, 48, 49) aus wenigstens zwei Stücken zusammengesetzt ist, so dass die ferromagnetischen Kerne um das Kabel (45) zusammengebaut werden können, ohne das Kabel abzuziehen.

5. Stromwandler nach einem der Ansprüche 1 bis 4, wobei die Magnetfeldsensoren Hallsensoren sind (1, 28), die in oder neben den Luftspalten ($G_1$, $G_2$, $G_3$, $G_4$) der ferromagnetischen Kerne (46, 47, 48, 49) platziert sind.

6. Stromwandler nach einem der Ansprüche 1 bis 4, wobei die Magnetfeldsensoren magnetoresistive Sensoren (19, 31) sind, die neben oder in den Luftspalten ($G_1$, $G_2$) der ferromagnetischen Kerne (46, 47) platziert sind.

7. Stromwandler nach einem der Ansprüche 1 bis 6, weiter umfassend
einen Transformator (3), der mit dem bzw. den Magnetfeldsensor(en) gekoppelt ist,
einen vollständig differenziellen Vorverstärker (4), der mit dem Transformator (3) gekoppelt ist,
einen phasenempfindlichen Detektor (6), der mit dem Vorverstärker (4) gekoppelt ist, and
einen Logikblock (5), der konfiguriert ist, die Magnetfeldsensoren derart zu betreiben, dass sie ein AC Ausgangssignal liefern.

8. Stromwandler nach einem der Ansprüche 1 bis 4, weiter umfassend
einen Transformator (3), der zwei Eingangsanschlüsse und zwei Ausgangsanschlüsse umfasst,
einen vollständig differentiellen Vorverstärker (4), der zwei Eingangsanschlüsse und zwei Ausgangsanschlüsse umfasst, wobei die zwei Eingangsanschlüsse mit den zwei Ausgangsanschlüssen des Transformators (3) gekoppelt sind,
einen phasenempfindlichen Detektor (6), der zwei Eingangsanschlüsse umfasst, die mit den Ausgangsanschlüssen des Vorverstärkers (4) gekoppelt sind, und der eine Ausgangsgleichspannung liefert, und
einen Logikblock (5, 5a), der ausgelegt ist, den Magnetfeldsensor zu betreiben, um eine Ausgangswechselspannung zu liefern, wobei
jeder Magnetfeldsensor ein Hall-Element (1) ist, das vier Anschlüsse umfasst, die dazu dienen, einen Speisestrom zu empfangen und eine Ausgangsspannung zu liefern, und der Logikblock (5) eine Schaltung zur Kopplung des Hallelementes (1) mit einer Stromquelle (2) und mit den Eingangsanschlüssen des Transformators (3) gemäss einem vorbestimmten Spinning Current Schema umfasst, oder wobei

jeder Magnetfeldsensor ein AMR-Sensor (19) ist, der vier Anschlüsse, die dazu dienen, einen Speisestrom zu empfangen und eine Ausgangsspannung zu liefern, und zwei Anschlüsse, die dazu dienen, Setz- und Rücksetzstrompulse zu empfangen, die die Polarität der Ausgangsspannung ändern, umfasst, wobei die Anschlüsse, die zum Empfangen eines Speisestroms dienen, mit einer Stromquelle (2) gekoppelt sind, und die Anschlüsse, die zum Ausgeben einer Ausgangsspannung dienen, mit den Eingangsanschlüssen des Transformators (3) gekoppelt sind, und die Anschlüsse, die zum Empfangen von Setz- und Rücksetzstrompulsen dienen, mit dem Logikblock (5) gekoppelt sind, und der Logikblock (5) eine Schaltung zum Liefern von Setz- und Rücksetzstrompulsen entsprechend einer vorgegebenen Frequenz umfasst, oder wobei

jeder Magnetfeldsensor ein Fluxgate-Sensor ist, der vier Anschlüsse umfasst, die dazu dienen, einen Erregerstrom zu empfangen und eine Ausgangsspannung zu liefern, wobei die Anschlüsse, die zum Empfangen des Erregerstroms dienen, mit einer Stromquelle (2) gekoppelt sind, und die Anschlüsse, die zum Liefern einer Ausgangsspannung dienen, mit den Eingangsanschlüssen des Transformators (3) gekoppelt sind, wobei der Logikblock (5c) eine Schaltung umfasst, um die Stromquelle (2) zu steuern, den Speisestrom als Wechselstrom mit einer vorgegebenen Frequenz bereitzustellen.

9. Stromwandler nach einem der Ansprüche 1 bis 8, der zusätzlich eine oder mehrere Spulen (52) umfasst, die um die ferromagnetischen Kerne (46; 47) gewickelt sind, und eine elektronische Schaltung, die ausgelegt ist, um vorübergehend einen Strom durch die eine oder mehreren Spulen (52) fliessen zu lassen, um die ferromagnetischen Kerne (46; 47) zu entmagnetisieren.

10. Stromwandler nach Anspruch 9, wobei um jeden ferromagnetischen Kern eine separate Spule gewickelt ist und wobei der Stromleiter zusätzlich eine elektronische Schaltung umfasst, die ausgelegt ist, einen separaten Strom durch jede der Spulen (52) fliessen zu lassen, um jeden der Magnetfeldsensoren in einem geschlossenen Regelkreis zu betreiben.

11. Stromwandler nach einem der Ansprüche 1 to 8, der weiter um jeden ferromagnetischen Kern (46; 47) eine separate, gewickelte Spule (52) umfasst, und eine elektronische Schaltung, die ausgelegt ist, durch jede der Spulen (52) einen separaten Strom fliessen zu lassen, um jeden der Magnetfeldsensoren in einem geschlossenen Regelkreis zu betreiben.

## Revendications

1. Transducteur de courant pour mesurer un courant circulant à travers un câble (45), le transducteur de courant comprenant une tête (40) comprenant au moins deux noyaux ferromagnétiques (46, 47, 48, 49) entourant le câble (45), chaque noyau (46, 47, 48, 49) ayant un entrefer ($G_1$, $G_2$, $G_3$, $G_4$) et un capteur de champ magnétique (57) placé à l'entrefer, dans lequel les noyaux ferromagnétiques (46, 47, 48, 49) sont disposés à peu près parallèlement les uns aux autres et espacés d'une distance prédéterminée le long d'un axe (50) et tourné par un angle de rotation prédéterminé autour de l'axe (50) par rapport de l'un à l'autre, de sorte que les entrefers ($G_1$, $G_2$) des noyaux ferromagnétiques (46, 47, 48, 49) sont situés à des angles différents.

2. Transducteur de courant selon la revendication 1, dans lequel le nombre des noyaux ferromagnétiques (46, 47) de la tête (40) est deux et l'angle de rotation prédéterminé est d'environ 180°, de sorte que les entrefers ($G_1$, $G_2$) des deux noyaux ferromagnétiques (46, 47) sont situés sur des côtés diamétralement opposés par rapport à l'axe (50).

3. Transducteur de courant selon la revendication 1, dans lequel le nombre des noyaux ferromagnétiques (46, 47, 48, 49) de la tête (40) est quatre et l'angle de rotation prédéterminé est d'environ 90°, de sorte que les entrefers ($G_1$, $G_2$, $G_3$, $G_4$) des quatre noyaux ferromagnétiques (46, 47, 48, 49) sont mutuellement en rotation pour un angle d'environ 90°.

4. Transducteur de courant selon une des revendications 1 à 3, dans lequel chaque noyau ferromagnétique (46, 47, 48, 49) est composé d'au moins deux pièces, de sorte que les noyaux ferromagnétiques peuvent être assemblés autour du câble (45) sans déconnecter le câble.

5. Transducteur de courant selon une des revendications 1 à 4, dans lequel les capteurs de champ magnétique sont des capteurs à effet Hall (1, 28), qui sont placés à l'intérieur ou à côté des entrefers ($G_1$, $G_2$, $G_3$, $G_4$) des noyaux ferromagnétiques (46, 47, 48, 49).

6. Transducteur de courant selon une des revendications 1 à 4, dans lequel les capteurs de champ magnétique sont des capteurs magnétorésistifs (19, 31), qui sont placés au voisinage ou à l'intérieur des entrefers ($G_1$, $G_2$) des noyaux ferromagnétiques (46, 47).

7. Transducteur de courant selon une des revendications 1 à 6, comprenant en outre
un transformateur (3) couplé au(x) capteur(s) de champ magnétique,

un pré-amplificateur entièrement différentiel (4) couplé au transformateur (3),

un détecteur sensible à la phase (6) couplé au pré-amplificateur (4), et

un bloc logique (5) configuré pour faire fonctionner les capteurs de champ magnétique pour fournir un signal de sortie AC.

8. Transducteur de courant selon une des revendications 1 à 4, comprenant en outre

un transformateur (3) comportant deux bornes d'entrée et deux bornes de sortie,

un pré-amplificateur entièrement différentiel (4) comprenant deux bornes d'entrée et deux bornes de sortie, les deux bornes d'entrée couplées auxdites deux bornes de sortie du transformateur (3),

un détecteur sensible à la phase (6) comportant deux bornes d'entrée couplées aux bornes de sortie du préamplificateur (4) et fournissant une tension de sortie continue, et

un bloc logique (5, 5a) configuré pour faire fonctionner le capteur de champ magnétique pour fournir une tension de sortie en courant alternatif, dans lequel

chaque capteur de champ magnétique est un élément à effet Hall (1) comprenant quatre bornes servant à recevoir un courant d'alimentation et à fournir une tension de sortie et le bloc logique (5) comprend un circuit pour coupler l'élément à effet Hall (1) à une source de courant (2) et aux bornes d'entrée du transformateur (3) selon un schéma prédéterminé de courant tournant ("spinning current"), ou dans lequel

chaque capteur de champ magnétique est un capteur AMR (19) comprenant quatre bornes servant à recevoir un courant d'alimentation et à fournir une tension de sortie et deux bornes servant à recevoir des impulsions de courant set et reset qui changent la polarité de la tension de sortie, dans lequel les bornes servant à recevoir un courant d'alimentation sont couplées à une source de courant (2), les bornes servant à délivrer une tension de sortie sont couplées aux bornes d'entrée du transformateur (3), et les bornes servant à recevoir des impulsions de courant SET et RESET sont couplées au bloc logique (5), et le bloc logique (5) comprend un circuit pour délivrer des impulsions de courant SET et RESET selon une fréquence prédéterminée, ou dans lequel chaque capteur de champ magnétique est un capteur à noyau saturable comprenant quatre bornes servant à recevoir un courant d'excitation et à délivrer une tension de sortie, dans lequel les bornes servant à recevoir le courant d'excitation sont couplées à une source (2) de courant et les bornes servant à délivrer un signal de sortie tension sont couplées aux bornes d'entrée du transformateur (3), dans lequel le bloc logique (5c) comprend un circuit pour commander la source de courant (2) à fournir le courant d'alimentation comme un courant alternatif ayant une fréquence prédéterminée.

9. Transducteur de courant selon une des revendications 1 à 8, comprenant en outre une ou plusieurs bobines (52) enroulées autour des noyaux ferromagnétiques (46; 47) et un circuit électronique configuré pour fournir temporairement un courant à travers les une ou plusieurs bobines (52) pour démagnétiser les noyaux ferromagnétiques (46; 47).

10. Transducteur de courant selon la revendication 9, dans lequel une bobine séparée est enroulée autour de chaque noyau ferromagnétique, le transducteur de courant comprenant en outre un circuit électronique configuré pour fournir un courant séparé à travers chacune des bobines (52) pour faire fonctionner chacun des capteurs de champ magnétique dans un mode en boucle fermée.

11. Transducteur de courant selon une des revendications 1 à 8, comprenant en outre une bobine séparée (52) enroulée autour de chaque noyau ferromagnétique (46; 47) et un circuit électronique configuré pour fournir un courant séparé à travers chacune des bobines (52) pour faire fonctionner chacun des capteurs de champ magnétique dans un mode en boucle fermée.

Fig. 1

Fig. 2

Fig. 3

Fig. 4

Fig. 5

Fig. 9

Fig. 6

Fig. 10

Fig. 7

Fig. 11

Fig. 8

Internal clock

Phase 1

Phase 2

Phase 3

Phase 4

$V_{Offset}$

$V_{hall}$

Fig. 12

Fig. 13

Fig. 14

Fig. 15

Fig.16

Fig. 17

Fig. 18

Fig. 19

Fig. 20

Fig. 21

Fig. 22

Fig. 23

Fig. 24A

Fig. 24B

Fig. 25

Fig. 26

Fig. 27

Fig. 28

**EP 2 682 764 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006071457 A